# EUROPEAN PATENT SPECIFICATION

(11) **EP 3 467 971 B1**
(45) Date of publication and mention of the grant of the patent: **08.07.2020**
(21) Application number: 17802943.5
(22) Date of filing: 26.05.2017
(51) Int. Cl.: H01S 3/06, H01S 3/02, H01S 3/08, H01S 3/11

(54) **SOLID-STATE LASER DEVICE**
FESTKÖRPERLASERVORRICHTUNG
DISPOSITIF LASER À SOLIDE

(30) Priority: 27.05.2016 JP 2016105871
(43) Date of publication of application: 10.04.2019
(73) Proprietor: FUJIFILM Corporation, Tokyo 106-8620 (JP)
(72) Inventor: ISHII, Hiroyasu, Ashigarakami-gun Kanagawa 258-0023 (JP)
(74) Representative: Klunker IP Patentanwälte PartG mbB
(86) International application number: PCT/JP2017/019805
(87) International publication number: WO 2017/204357

(56) References cited:
- WO-A1-2016/051664
- JP-A- S6 182 488
- JP-A- H01 230 276
- JP-A- H05 218 530
- JP-A- 2003 008 118
- JP-A- 2003 008 118
- JP-A- 2004 241 488
- JP-A- 2007 096 063
- JP-A- 2011 018 815
- JP-A- 2015 192 044
- US-A- 5 172 388
- US-A1- 2011 158 271

## Description

### BACKGROUND OF THE INVENTION

### 1. Field of the Invention

The present invention relates to a solid-state laser device including a laser rod, which is made of a solid-state laser crystal, as a laser medium.

### 2. Description of the Related Art

For example, a solid-state laser device is composed of a resonator; a rod-shaped solid-state laser medium (laser rod) disposed in the resonator; an excitation light source, such as a flash lamp, for exciting the laser rod; and optical members, such as a Q switch. In many cases, in order to efficiently irradiate the laser rod with excitation light emitted from the excitation light source, the laser rod and the excitation light source are contained in a laser chamber in such a way that at least parts thereof are enclosed in the laser chamber.

JP1999-87806A (JP-H11-87806A) describes that a solid-state laser device has the following problem: return light from an optical component or the like to a laser rod is incident on an O-ring, which is disposed at an exposed root of an end portion of the laser rod exposed from the laser chamber that contains the laser rod; the return light burns the O-ring; and cinders of the O-ring adhere to an end surface of the laser rod and damages an antireflection film on the end surface of the laser rod. In order to protect the end surface of the laser rod from the damage due to the return light of laser light, JP1999-87806A (JP-H11-87806A) proposes a structure in which a holder block, which includes an opening smaller than the diameter of the laser rod, is disposed at a position facing the end surface of the laser rod so that the return light is not incident on the O-ring. JP1999-87806A (JP-H11-87806A) describes that, although the size of the opening of the holder block is smaller than the diameter of the laser rod, this is not a problem because a region in which reflection occurs is limited to a region where laser output power is extremely low, because laser light gradually converges due to a thermal lens effect.

JP2007-96063A discloses a solid-state laser device that includes a mode limiting aperture in order to ensure the beam quality of oscillation laser light. In general, a mode limiting aperture is used to selectively oscillate the lowest-order eigenmode.

Another solid-state laser device of interest is described in JP 2003 008118 A.

### SUMMARY OF THE INVENTION

In general, optical surfaces of many optical elements are covered with optical films in accordance with the functions of the optical elements. As described in JP11-87806A, a laser rod includes, as an optical film, an antireflection film on an end surface thereof.

An optical film, which is usually disposed on a smooth surface, is not likely to satisfactorily adhere to a rough surface (ground-glass-like) portion. An edge between adjacent surfaces of an optical member is typically chamfered in order to prevent chipping, and the chamfered portion generally has a rough surface. In a general optical member, the chamfered portion is not used as a light beam transmitting region (light path). However, regarding a laser rod, the rod itself is usually the light path, and the chamfered portion is also in the laser light path and is a region through which laser light passes.

Regarding solid-state laser devices, demands for reduction in pulse width and reduction in size are increasing. Use of a small-diameter laser rod is considered as means for realizing shorter pulse width and smaller size. When the same excitation light is absorbed, energy density increases and a shorter-pulse-width laser is obtained as the diameter of the laser rod becomes smaller.

The inventors found that, when a laser rod includes a chamfered portion around an end surface thereof, there is a case where breakage of an optical film on the end surface occurs from the origin on the outer periphery of the end surface, which is the boundary between the optical film and the chamfered portion. To be specific, the inventors found that breakage of the optical film occurs when, as described above, the diameter of the laser rod is small and the energy at the cross section of the light path is very high.

On the background described above, it is an object of the present invention to provide a solid-state laser device that suppresses occurrence of breakage of an optical film on an end surface of a laser rod and that can be stably driven for a long period.

A solid-state laser device according to the present invention includes a resonator composed of a pair of mirrors; a laser rod disposed in the resonator, the laser rod including an antireflection film on an end surface thereof and having a chamfered portion at a peripheral edge of the end surface; and an end-surface protection member that is disposed at a position facing the end surface of the laser rod, that is attached to and covering an end portion of the laser rod, that has an opening defining portion that forms an opening whose diameter is smaller than a diameter of an outer periphery of the end surface, and that limits a laser light path region in the end surface of the laser rod to a region inside of the outer periphery of the end surface.

In the solid-state laser device according to the present invention, preferably, a distance between the opening defining portion of the end-surface protection member and the end surface of the laser rod is 0.5 mm or smaller.

In the solid-state laser device according to the present invention, preferably, the opening defining portion of the end-surface protection member and the end surface of the laser rod are in contact with each other.

In the solid-state laser device according to the present invention, preferably, the opening defining portion of the end-surface protection member includes a tapered portion whose opening diameter decreases toward the laser rod.

In the solid-state laser device according to the present invention, preferably, the end-surface protection member has a tubular portion that supports the opening defining portion, and the tubular portion is fitted onto and attached to an end portion of the laser rod including the end surface.

Preferably, the solid-state laser device according to the present invention includes a laser chamber that contains at least a part of the laser rod and that has a hole having a columnar shape that is shorter than a longitudinal axial length of the laser rod, the laser rod is inserted through the hole of the laser chamber and is supported by the laser chamber in a state in which both end portions of the laser rod are exposed from the hole, and the tubular portion of the end-surface protection member has a shape that covers an entire region of a side surface of the end portion exposed from the hole.

In the solid-state laser device according to the present invention, preferably, a laser chamber that contains at least a part of the laser rod and that has a hole having a columnar shape that is shorter than a longitudinal axial length of the laser rod; the laser rod is inserted through the hole of the laser chamber and is supported by the laser chamber in a state in which both end portions of the laser rod are exposed from the hole; an O-ring is disposed at an exposed root of an end portion of the laser rod including the end surface where the end-surface protection member is disposed, the exposed root being exposed from the hole of the laser chamber; and the solid-state laser device includes a cover member that is disposed on a side surface of the laser rod between the O-ring and the end surface and that blocks incidence of stray light on the O-ring.

In the solid-state laser device according to the present invention, preferably, the end-surface protection member is made of at least one of a ceramic, glass, or a fluororesin.

In the solid-state laser device according to the present invention, preferably, the laser rod is made of an alexandrite crystal.

In the solid-state laser device according to the present invention, preferably, a rod diameter of the laser rod is 3 mm or smaller.

The solid-state laser device according to the present invention includes a resonator composed of a pair of mirrors; a laser rod disposed in the resonator, the laser rod including an antireflection film on an end surface thereof and having a chamfered portion at a peripheral edge of the end surface; and an end-surface protection member that is disposed at a position facing the end surface of the laser rod, that has an opening defining portion that forms an opening whose diameter is smaller than a diameter of an outer periphery of the end surface, and that limits a laser light path region in the end surface of the laser rod to a region inside of the outer periphery of the end surface. Therefore, occurrence of breakage of the antireflection film on the end surface can be effectively suppressed. Moreover, by suppressing breakage of the antireflection film on the laser rod end surface, the solid-state laser device can be driven stably for a long period.

### BRIEF DESCRIPTION OF THE DRAWINGS

Fig. 1 is a schematic perspective view of a solid-state laser device according to an embodiment;
Fig. 2 is a schematic side view of the solid-state laser device according to the embodiment;
Fig. 3 is a schematic plan view of the solid-state laser device according to the embodiment;
Fig. 4 is a perspective view of a laser chamber;
Fig. 5 is an enlarged sectional view of a region near an end portion of a laser rod exposed from the laser chamber;
Fig. 6 shows a front view of an end surface of the laser rod and a side view of the end portion of the laser rod;
Fig. 7 is a perspective view of an end-surface protection member;
Fig. 8 illustrates the distance d between an opening defining portion and a rod end surface;
Fig. 9 is an enlarged sectional view of a region near an end portion of a laser rod including an end-surface protection member according to a design modification;
Fig. 10 is an enlarged sectional view of a region near an end portion of a laser rod of a solid-state laser device according to a design modification; and
Fig. 11 is a side view of a region near an end portion of a laser rod including a cover member according to a design modification.

### DESCRIPTION OF THE PREFERRED EMBODIMENTS

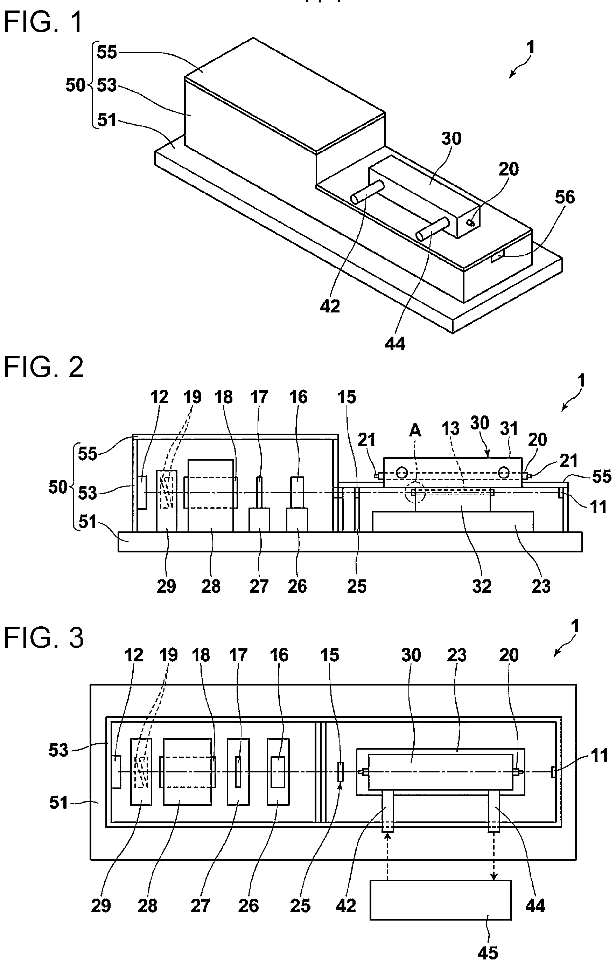

Hereinafter, embodiments of the present invention will be described with reference to the drawings. Fig. 1 is a schematic perspective view of a solid-state laser device according to an embodiment of the present invention. Figs. 2 and 3 are respectively a schematic side view and a schematic plan view of the solid-state laser device according to the present embodiment, in each of which a part of a housing is omitted and the arrangement of elements in the housing is schematically shown.

A solid-state laser device 1 includes a pair of mirrors 11 and 12 that constitute a resonator, a laser rod 13 that is disposed in the resonator, and a laser chamber 30 that contains at least a part of the laser rod 13. The solid-state laser device 1 further includes optical members between the mirror 12 and the laser rod 13. The optical members are an aperture member 15, a polarizer 16, a shutter 17, a Q switch 18, and a wedge prism pair 19. The mirrors 11 and 12, the laser rod 13, and the optical members 15 to 19 are disposed in a housing 50. A part of the laser chamber 30 is exposed from the housing 50 to the outside, and a flash lamp 20 is contained in the part of the laser chamber 30 exposed from the housing 50. The housing 50 is composed of a base 51, a side wall portion 53, and a lid portion 55, and includes an emission opening 56, for outputting laser light, in a part of the side wall portion 53.

The pair of mirrors 11 and 12 are disposed so as to face each other with the laser rod 13 therebetween and constitute a linear resonator. The mirror 11 is a partially transmissive mirror and functions as a so-called output mirror that outputs laser light. The mirror 12 is a high reflection mirror and functions as a so-called rear mirror. In the present embodiment, the mirror 11 is a planar mirror, and the mirror 12 is a concave mirror. Hereinafter, the mirrors 11 and 12 may be respectively referred to as an output mirror 11 and a rear mirror 12. In the present embodiment, the output mirror 11 and the rear mirror 12 face each other and are attached to side surfaces, in the transversal direction, of the side wall portion 53 of the housing 50.

In the solid-state laser device 1 according to the present embodiment, a linear optical resonator is constituted by the mirrors 11 and 12. However, instead of a linear resonator, a solid-state laser device according to the present invention may include, for example, an L-shaped, Z-shaped, or an X-shaped resonator structure that includes prisms and mirrors, for changing the direction of light, in the light path. On the other hand, in view of reduction in size and cost, the number of optical members is preferably smaller, and a linear resonator is most preferable.

The laser rod 13, which is a solid-state laser medium, is made by forming a solid-state laser crystal, such as alexandrite (Cr:BeAl₂O₃), neodymium YAG (Nd:YAG (yttrium aluminum garnet)), titanium-sapphire (Ti:Al₂O₃), into a rod shape. The term "rod shape" refers to an elongated cylindrical shape such that the distance between two discs, which are end surfaces, is larger than the diameter of the discs. A solid-state laser medium is not limited to the one described above, and another known laser medium may be used, as appropriate. Preferably, the laser rod 13 has a small diameter in order to reduce the size of the entire device. In the present embodiment, particularly preferably, the laser rod 13 is made of alexandrite; and, preferably, the diameter of a cross section (circular cross section) perpendicular to the longitudinal direction of the laser rod 13 (hereinafter, referred to as "the rod diameter") is 4 mm or smaller. More preferably, the rod diameter is 3 mm or smaller, and further preferably, 2.5 mm or smaller. The length of the laser rod is preferably 75 mm or smaller, and more preferably, 60 mm or smaller.

The flash lamp 20 is an excitation light source that emits excitation light for exciting the laser rod 13. The entirety of the flash lamp 20, including terminals 21 at both ends thereof, is substantially bar-shaped. The length of the flash lamp 20 is, for example, about 10 cm. The length of the flash lamp 20 is defined as the length of the flash lamp 20 including the terminals 21 in the longitudinal direction. Lead wires (not shown) are connected to the two terminals 21, and the flash lamp 20 is connected to a lighting power source via the lead wires. To be more specific, for example, a xenon flash lamp or the like can be used as the flash lamp 20. An excitation light source of a solid-state laser device according to the present invention is not limited to the flash lamp 20. For example, a light source in which a plurality of LEDs (light-emitting diodes) are arranged in a transparent linear tube and that has a bar-like shape as a whole may be used.

The laser chamber 30 is made of, for example, a metal, and is configured to contain the laser rod 13 and the flash lamp 20. The laser chamber 30 has an inner space for containing the laser rod 13 and the flash lamp 20, and transmits light that is emitted from the flash lamp 20 in the inner space to the laser rod 13. For example, a reflection surface is formed inside the laser chamber 30, and the laser rod 13 is directly irradiated with light emitted from the flash lamp 20 or is irradiated with light emitted from the flash lamp 20 and reflected by the reflection surface.

Pipes 42 and 44 are connected to a side wall of the laser chamber 30. As schematically illustrated in Fig. 3, the laser chamber 30 is connected to a cooling device 45 via the pipes 42 and 44. The cooling device 45 is a device for cooling the laser rod 13 and the flash lamp 20. The cooling device 45 supplies a coolant, such as pure water, into the laser chamber 30 via the pipe 42. The cooling device 45 receives coolant drained from the laser chamber 30 through the pipe 44, reduces the temperature of the coolant, and supplies the coolant into the laser chamber 30 again. By circulating the coolant in this way, the temperature of the laser rod 13 in the laser chamber 30 can be maintained in a desirable temperature range.

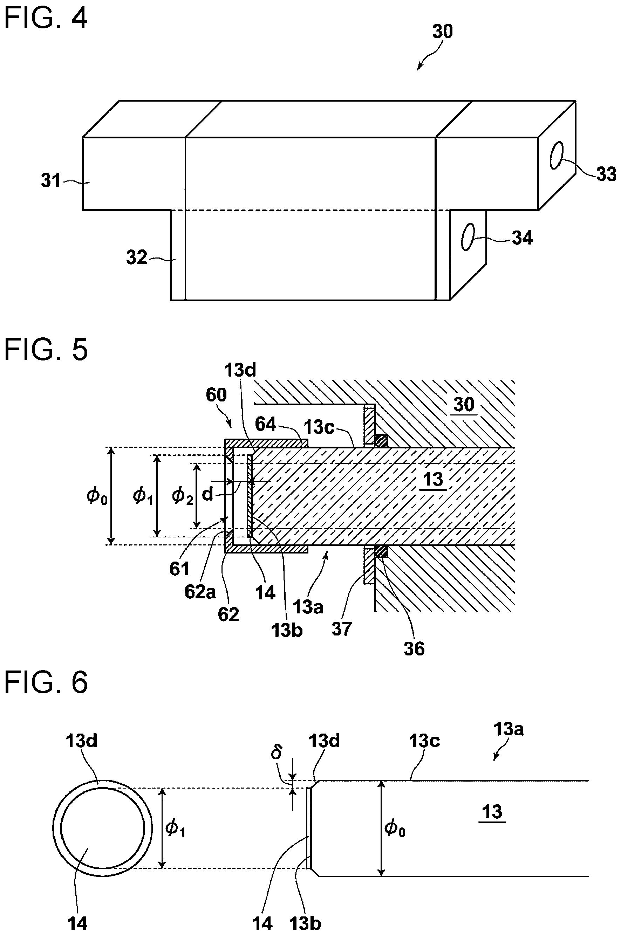

Fig. 4 is an external perspective view of the laser chamber 30. In Fig. 4, holes and the like for connecting the pipes 42 and 44 (see Fig. 1) are omitted. The laser chamber 30 has a first portion 31 for containing the flash lamp 20 and a second portion 32 for containing the laser rod 13. The first portion 31 includes, as a space for containing the flash lamp 20, a hole 33 that extends therethrough from one of wall surfaces perpendicular to the longitudinal direction to the other of the wall surfaces. The second portion 32 includes, as a space for containing the laser rod 13, a hole 34 that extends therethrough from one of wall surfaces perpendicular to the longitudinal direction to the other of the wall surfaces. That is, the two holes 33 and 34 extend parallel to each other in the longitudinal direction of the laser chamber 30.

The hole 34 of the laser chamber 30 has a cylindrical shape that is shorter than the longitudinal axial length of the laser rod 13. The laser rod 13 is inserted into the hole 34 and supported in a state in which both end portions thereof are exposed. The flash lamp 20 is supported by being inserted through the hole 33 (see Fig. 2). As long as the hole 34 can accommodate the laser rod 13, the shape of the hole 34 is not limited to a cylindrical shape, and may be a prismatic shape, an elliptical-cylindrical shape, or the like. The flash lamp 20 can be inserted into or extracted from the laser chamber 30 in the longitudinal direction on the right side in the figures. In the present embodiment, the length of the first portion 31 of the laser chamber 30 in the longitudinal direction is larger than the length of the second portion 32 in the longitudinal direction. However, the lengths of the first portion 31 and the second portion 32 in the longitudinal direction may be the same as each other.

As illustrated in Fig. 2, the laser chamber 30 is supported by a support base 23 in such a way that the first portion 31, which contains the flash lamp 20, protrudes from the lid portion 55 of the housing 50 to the outside, and the second portion 32, which contains the laser rod 13, is disposed in the housing 50. The flash lamp 20 can be replaced in a state in which the lid portion 55 is closed.

Fig. 5 is an enlarged sectional view of a region near one end portion of the laser rod 13 exposed from the laser chamber 30 (a region A surrounded by a broken line in Fig. 2).

As illustrated in Fig. 5, an O-ring 36 is disposed at an exposed root of an end portion 13a of the laser rod 13 (hereinafter, referred to as "a rod end portion 13a") exposed from the hole 34 of the laser chamber 30. Moreover, an O-ring pressing plate 37 that has a through-hole, which allows the laser rod 13 to extend therethrough, is disposed adjacent to the O-ring 36 and between the O-ring 36 and an end surface 13b of the laser rod 13 (hereinafter, referred to as "the rod end surface 13b"). The phrase "the exposed root of the end portion 13a exposed from the hole 34 of the laser chamber 30" refers to a part of the rod end portion 13a that is exposed from the hole 34 of the laser chamber 30 and that is most adjacent to the laser chamber 30 (that is, adjacent to the hole 34). Hereinafter, the exposed root exposed from the hole 34 of the laser chamber 30 may be referred to the exposed root exposed from the laser chamber. The O-ring 36 is fitted onto the laser rod 13 and is disposed in an O-ring receiving portion formed at an end portion of the hole 34 of the laser chamber 30. By fixing the O-ring pressing plate 37 onto the laser chamber 30 with screws, the O-ring 36 is urged toward the laser chamber 30, and the laser rod 13 is fixed. Basically, the O-ring 36 and the O-ring pressing plate 37 are disposed at each of two end portions of the laser rod 13 that are exposed from the laser chamber 30.

Fig. 6 shows a front view of an end surface of the laser rod 13 (in a left part of the figure) and a side view of an end portion of the laser rod 13 (in a right part of the figure). As illustrated in Fig. 6, the laser rod 13 includes a chamfered portion 13d between the end surface 13b (hereinafter, referred to as "the rod end surface 13b") and a side surface 13c (hereinafter, referred to as "the rod side surface 13c"). That is, the laser rod 13 has the chamfered portion 13d at a peripheral edge of the end surface 13b, which is outside of the outer periphery of the end surface 13b in the radial direction. The chamfered portion 13d is a rough surface. The laser rod 13 includes an antireflection film 14 on the rod end surface 13b. Although only one end surface of the laser rod is shown in Fig. 6, both end surfaces have the same configuration. Preferably, the laser rod 13 includes the antireflection film 14 on the entirety of the rod end surface 13b.

The width δ of the chamfered portion 13d, which corresponds to the difference between the radius of the laser rod 13 and the radius of the outer periphery of the end surface, is about 1 to 5% of the rod diameter φ₀, and preferably, about 2% of the rod diameter φ₀. For example, when the rod diameter φ₀ is 2.5 mm, the width δ of the chamfered portion 13d is 0.05 mm.

As illustrated in Fig. 5, the solid-state laser device 1 includes an end-surface protection member 60 at a position facing the rod end surface 13b. The end-surface protection member 60 has an opening defining portion 62 that forms an opening 61 having a diameter φ₂ that is smaller than the diameter φ₁ of the outer periphery of the rod end surface 13b. The end-surface protection member 60 limits a laser light path region of the rod end surface 13b to a region inside of the outer periphery of the rod end surface 13b. If the solid-state laser device 1 does not include the end-surface protection member 60, the entire region in the laser rod 13 is the light path, and the cross section of the light path is the same as a circular cross section having the diameter φ₀. However, because the solid-state laser device 1 includes the end-surface protection member 60, the light path is limited to a region having a circular cross section with the diameter φ₂, which is shown by a two-dot chain line in Fig. 5.

Because the solid-state laser device 1 includes the end-surface protection member 60 as described above, the laser light path region is limited to the region inside of the outer periphery of the rod end surface 13b, that is, a region inside of the inner periphery of the chamfered portion 13d. Accordingly, during laser oscillation, the boundary between the rod end surface 13b and the chamfered portion 13d is not irradiated with laser light. As described above, the boundary between the rod end surface 13b and the chamfered portion 13d is a region in which coating of an optical film is not satisfactory and that tends to become the origin of coating breakage. However, as long as the boundary is not irradiated with high-energy laser light, occurrence of coating breakage can be suppressed. That is, because the solid-state laser device 1 includes the end-surface protection member 60, occurrence of coating breakage at the rod end surface 13b can be suppressed.

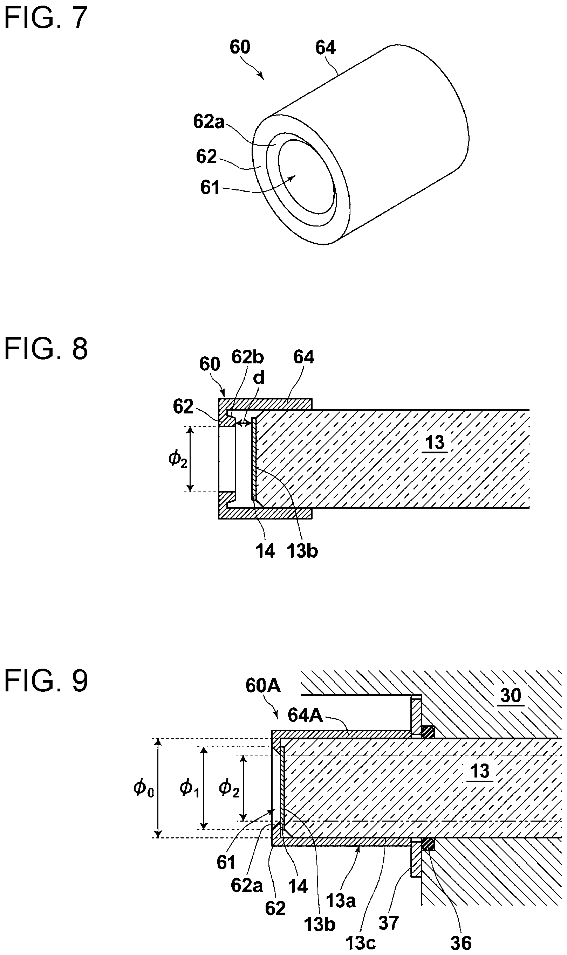

Fig. 7 is a perspective view of the end-surface protection member 60 according to the present embodiment. As shown in Fig. 7, the end-surface protection member 60 has a tubular portion 64 that supports the opening defining portion 62, and the tubular portion 64 has a cap-like shape that is fitted onto and attached to the rod end portion 13a. The shape of the end-surface protection member 60 is not particularly limited, as long as the end-surface protection member 60 can stably support the opening defining portion 62 at a position near the rod end surface 13b. However, as in the present embodiment, a cap-like shape that can be fitted and attached is preferable, because positional accuracy can be easily ensured.

It is important that the opening defining portion 62 be disposed at a position that is extremely close to the rod end surface 13b so as to cover the boundary between the rod end surface 13b and the chamfered portion 13d. The term "extremely close to" means that the distance d between the rod end surface 13b and the opening defining portion 62 (see Fig. 5) does not significantly differ in advantageous effect from a state in which the rod end surface 13b and the opening defining portion 62 are in contact with each other (that is, d = 0). To be specific, preferably, the distance d is 0.5 mm or smaller, more preferably 0.1 mm or smaller, and particularly preferably, the rod end surface 13b and the opening defining portion 62 are in contact with each other. Note that, because the antireflection film 14 is disposed on the surface of the rod end surface 13b, in the present specification, the phrase "the distance between the opening defining portion 62 and the rod end surface 13b" means the distance between the opening defining portion 62 and the surface of the antireflection film 14 on the rod end surface 13b. Likewise, the phrase "the rod end surface 13b and the opening defining portion 62 are in contact with each other" means that the surface of the antireflection film 14 on the rod end surface 13b and the opening defining portion 62 are in contact with each other.

As illustrated in Figs. 5 and 7, preferably, the opening defining portion 62 of the end-surface protection member 60 includes a tapered portion 62a having an opening diameter that decreases toward the rod end surface 13b. When the opening defining portion 62 includes the tapered portion 62a, reflection of light in the light path by the opening defining portion 62 can be suppressed.

The distance between the opening defining portion 62 and the rod end surface 13b is defined as the distance between a part of the opening defining portion 62 that has the diameter φ₂ and that is most adjacent to the rod end surface 13b and the rod end surface 13b. For example, as shown in Fig. 8, in a case where a part 62b of the opening defining portion 62 having the diameter φ₂ protrudes toward the rod end surface 13b, the distance from a surface of the protruding part 62b adjacent to the rod end surface 13b to the rod end surface 13b is the distance d between the opening defining portion 62 and the rod end surface 13b.

The end-surface protection member 60 may be disposed at each of two end surfaces of the laser rod 13, or may be disposed at one of the two end surfaces. Even when the end-surface protection member 60 is disposed at only one of the end surfaces, the end-surface protection member 60 provides an advantageous effect of limiting the laser oscillation region. When a small-diameter laser rod is used to meet the demands for reduction in size of the device and reduction in pulse width, opening limitation greatly affects laser output power. That is, when disposing the end-surface protection members at both end portions of a small-diameter laser rod, the laser output power becomes highly sensitive to the production accuracy and the positional accuracy of the end-surface protection members, and may lead to decrease in stability and increase in manufacturing cost. Accordingly, preferably, the protection member is disposed at only one end surface.

Because the opening defining portion 62 of the end-surface protection member 60 contacts the laser light path, it is necessary that the opening defining portion 62 be made of a material that is not damaged or deformed by laser light and that generates only small amounts of dust and outgas. Accordingly, a ceramic or a fluororesin is suitable as the material of the opening defining portion 62. Preferably, the entirety of the end-surface protection member 60, including the opening defining portion 62, is made of at least one of a ceramic or a fluororesin.

Fig. 9 is a sectional view of an end-surface protection member according to a first design modification.

An end-surface protection member 60 illustrated in Fig. 9 has a length such that the opening defining portion 62 contacts the rod end surface 13b (here, the antireflection film 14 formed on the rod end surface 13b) and a tubular portion 64A abuts against the O-ring pressing plate 37, which is disposed at the exposed root of the laser rod 13 exposed from the laser chamber 30. Preferably, the end-surface protection member 60A has a cover-like shape that entirely covers the exposed portion of the rod side surface 13c of the rod end portion 13a exposed from the laser chamber 30 as described above, because, in this case, the positional accuracy of the opening defining portion 62 relative to the rod end surface 13b can be increased. When the solid-state laser device 1 includes the end-surface protection member 60A having a shape that covers up to the exposed root of the laser rod 13, it is possible to suppress incidence of stray light, which is generated in the housing 50, on the O-ring 36, which is disposed at the exposed root of the laser rod 13 exposed from the laser chamber 30. If stray light is incident on the O-ring 36, dust or outgas may be generated from the O-ring 36; and the dust and the outgas may adhere to the rod end surface, may be burnt, and may damage the rod end surface. However, because the end-surface protection member 60A can suppress incidence of stray light on the O-ring 36, damage to the laser rod can be more effectively prevented.

Next, other elements of the solid-state laser device will be described concisely.

As described above, the solid-state laser device 1 includes optical members on the rear mirror 12 side of the laser rod 13. The optical members are the aperture member 15, the polarizer 16, the shutter 17, the Q switch 18, and the wedge prism pair 19. The aperture member 15 is disposed most adjacent to the laser rod 13. Due to such disposition, the aperture member 15 can suppress propagation of stray light, which is generated by the polarizer 16, the shutter 17, the Q switch 18, the wedge prism pair 19, the rear mirror 12, or the like, toward the laser rod 13. The aperture member 15, which has an opening in the light path, can block stray light that propagates from the optical members 16 to 19 toward the laser rod 13 with a comparatively large angle and that considerably deviates from the light path, and can prevent the stray light from being incident on the laser chamber 30.

It is necessary that the aperture member 15 generate only small amounts of dust and outgas, absorb only a small amount of laser light, and have heat resistance. Preferably, the aperture member 15 is made of a material that can diffuse laser light. Accordingly, a ceramic, ground glass, or a fluororesin such as polytetrafluoroethylene (polytetrafluoroethylene; PTFE) is suitable as the material of the aperture member 15.

In order to prevent stray light from being incident on the laser chamber 30, preferably, the aperture member 15 is disposed between the laser chamber 30 and the other optical members 16 to 19 as in the present embodiment. The opening diameter of the aperture member 15 is preferably larger than or equal to the rod diameter φ₀, and more preferably, larger than the rod diameter φ₀. In particular, when a small-diameter laser rod having a rod diameter φ₀ of 4 mm or smaller is used as the laser rod 13 for the purpose of reduction in size of the device and reduction in pulse width of laser light, opening limitation by the aperture member 15 considerably affects the laser output power. That is, because the laser output power is highly sensitive to the positional accuracy of the aperture member 15 for a small-diameter laser rod, if the positional accuracy of the aperture member 15 is low, decrease in stability occurs. On the other hand, increasing the positional accuracy leads to increase in manufacturing cost. Accordingly, when using a small-diameter laser rod, preferably, the opening diameter of the aperture member is larger than the rod diameter. However, because the effect of blocking stray light may not be sufficiently obtained if the opening diameter of the aperture member is too large, preferably, the opening diameter is 120% of the rod diameter or smaller. Preferably, the opening shape of the aperture member 15 is similar to the end surface shape of the laser rod 13.

In the present embodiment, the aperture member 15 is disposed only on the rear mirror 12 side of the laser rod 13. Preferably, the aperture member 15 is disposed on each of two sides on which the end surfaces of the laser rod 13 are located, in view of protection by blocking of stray light. However, when disposing the aperture member 15 on each of two sides on which the end surfaces of the laser rod 13 are located, requirement for positional accuracy becomes stricter, and leads to increase in manufacturing cost. This predominantly occurs particularly when the rod has a small diameter. In the present embodiment, by disposing the optical members 16 to 19 only on the rear mirror 12 side of the laser rod 13, main points where stray light is generated are shifted toward one side. Therefore, a sufficiently high protection effect can be obtained even when the aperture member 15 is disposed only on one side.

The polarizer 16 selectively outputs a component of oscillated laser light that is linearly polarized in a predetermined direction. The shutter 17, which controls emission of laser light, mechanically blocks emission of laser light by being controlled to be opened or closed. The Q switch 18 performs a so-called Q switch operation so as to generate high-power pulsed laser light. However, a solid-state laser device according to the present invention is not limited to a device that generates pulsed laser light in this way, and may be configured to perform a CW (continuous wave) operation. The wedge prism pair 19 is used to perform optical-system adjustments, such as correction of the optical axis, by adjusting the positions and the angles of the prism pair. With the wedge prism pair 19, it is possible to perform highly-accurate optical axis adjustment.

The optical members 15 to 19 are respectively attached to holders 25 to 29, and the holders 25 to 29 are disposed on the base 51 of the housing 50. Note that the optical members 15 to 19 may be provided as necessary. For example, a solid-state laser device according to the present invention may include, among the optical members, only the Q switch. As necessary, the solid-state laser device may include another optical member.

With the solid-state laser device 1, when the Q switch 18 is switched to a light blocking state and the flash lamp 20 is turned on, the laser rod 13 is excited by excitation light emitted from the flash lamp 20, and a strong population inversion state is formed. Then, when the Q switch 18 is switched to a light transmitting state, light that is emitted from the laser rod 13 by stimulated emission resonates between the mirrors 11 and 12, the light becomes high-power giant pulse and passes through the output mirror 11, and the light is emitted to the outside of the resonator. The flash lamp 20 and the laser rod 13, which generate heat, are cooled by a coolant that flows through the laser chamber 30.

The solid-state laser device 1, which includes the end-surface protection member 60 at the end surface 13b of the laser rod 13, can suppress coating breakage of the antireflection film 14 on the rod end surface 13b and can obtain laser output power that is stable for a long period.

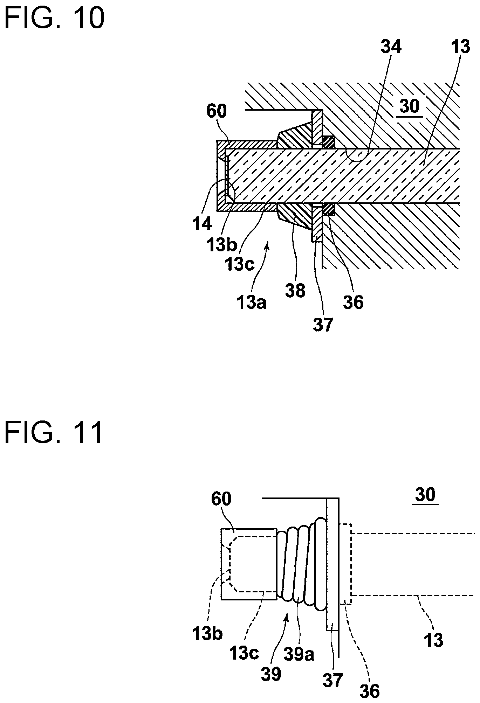

Fig. 10 is an enlarged sectional view of an exposed portion of a laser rod exposed from the laser chamber 30 of a solid-state laser device according to a design modification of the embodiment described above.

In the present design modification, the solid-state laser device 1 includes a cover member 38 that suppresses incidence of stray light on the O-ring 36 at the exposed root of the laser rod 13 exposed from the laser chamber 30.

As illustrated in Fig. 10, the solid-state laser device according to the present embodiment includes the cover member 38 that is disposed on the rod side surface 13c between the rod end surface 13b and the O-ring 36, which is fitted onto the rod end portion 13a. The cover member 38 blocks incidence of stray light, which is generated in the housing 50, on the O-ring 36.

With the solid-state laser device according to the present embodiment, which includes the cover member 38, incidence of stray light on the O-ring 36 can be prevented, as in the case where the solid-state laser device includes the end-surface protection member 60A shown in Fig. 9. Therefore, the solid state laser device can effectively suppress generation of dust or gas, and can suppress damage to the laser rod 13.

The cover member 38 is preferably disposed at each of two end portions of the laser rod, but may be disposed at only one end portion. When disposing the cover member 38 only at one end portion of the laser rod, preferably, the cover member 38 is disposed on a side on which a larger number of optical members such as the Q switch and the polarizer, which may cause generation of stray light, are disposed.

It is necessary that the cover member 38 generate only small amounts of dust and outgas, absorb only a small amount of laser light, and have heat resistance. Preferably, the cover member 38 can diffuse laser light. Accordingly, the cover member 38 is preferably made of at least one of a ceramic, ground glass, or a fluororesin such as polytetrafluoroethylene (polytetrafluoroethylene; PTFE). In order to prevent incidence of stray light on the O-ring 36, a soft material that can closely contact the laser rod 13 is preferable. Accordingly, a fibrous ceramic or glass, an unbaked fluororesin, or the like is particularly suitable.

Fig. 11 is an enlarged view of a region near an end portion of a laser rod including a cover member 39 according to a design modification. The cover member 39 illustrated in Fig. 11 is formed by winding a tape 39a, which is made of PTFE, multiple times around the rod side surface 13c. The cover member 39 formed by winding the tape 39a multiple times is preferable, because the cover member 39 can closely adhere to the laser rod 13 and the size thereof can be freely changed in accordance with the number of turns. By winding the tape 39a to such a degree that the O-ring 36 cannot be seen when viewed from the rod end surface 13b side, incidence of stray light on the O-ring 36 can be effectively suppressed.

In Fig. 11, if it is possible to sufficiently urge the O-ring 36 with the cover member 39 and to fix the laser rod 13, the O-ring pressing plate may be omitted.

As the O-ring 36, a general O-ring made of a rubber, which is not a fluorocarbon rubber, may be used. However, preferably, the O-ring 36 is made of a material that generates only small amounts of dust and outgas, such as a fluorocarbon rubber.

As illustrated in Fig. 10, when the O-ring pressing plate 37 is provided, stray light may be incident on the O-ring pressing plate 37 and dust and outgas may be generated. Therefore, preferably, the O-ring pressing plate 37 is also made of a material that generates only small amounts of dust and outgas, such as a ceramic or a fluororesin. Also preferably, the size of the cover member may be increased to suppress incidence of stray light on the O-ring pressing plate.

As illustrated in Figs. 10 and 11, by using a combination of the end-surface protection member 60 and the cover member 38 or 39 for suppressing incidence of stray light on the O-ring, it is possible to more effectively suppress damage to the laser rod and to realize stability for a longer period.

In each of the embodiments, a solid-state laser device in which a resonator, a laser rod, and optical members are disposed in a housing has been described. However, a solid-state laser device according to the present invention is not limited to a device in which these elements are disposed in a housing, and need not include a housing.

A solid-state laser device according to the present invention can be used for various purposes, which are not particularly limited. For example, a solid-state laser device according to the present invention can be used as a measurement light source that generates laser light (in particular, pulsed laser light), with which a subject is irradiated for detection of photoacoustic waves, in a photoacoustic measurement device described in JP2012-196430A, JP2014-207971A, or the like.

### Reference Signs List

- 1: solid-state laser device
- 11: output mirror
- 12: rear mirror
- 13: laser rod
- 13a: rod end portion
- 13b: rod end surface
- 13c: rod side surface
- 13d: chamfered portion
- 14: antireflection film
- 15: aperture member
- 16: polarizer
- 17: shutter
- 18: Q switch
- 19: wedge prism pair
- 20: flash lamp
- 21: terminal
- 23: support base
- 25 to 29: holder
- 30: laser chamber
- 31: first portion
- 32: second portion
- 33, 34: hole
- 36: O-ring
- 37: O-ring pressing plate
- 38, 39: cover member
- 39a: tape
- 42, 44: pipe
- 45: cooling device
- 50: housing
- 51: base
- 53: side wall portion
- 55: lid portion
- 56: emission opening
- 60, 60A: end-surface protection member
- 61: opening
- 62: opening defining portion
- 62a: tapered portion
- 62b: protruding part of opening defining portion
- 64, 64A: tubular portion

## Claims

1. A solid-state laser device (1) comprising:
a resonator composed of a pair of mirrors (11,12);
a laser rod (13) disposed in the resonator, the laser rod (13) comprising an antireflection film (14) on an end surface (13b) thereof and having a chamfered portion (13d) at a peripheral edge of the end surface (13b); and
an end-surface protection member (60) that is disposed at a position facing the end surface (13b) of the laser rod (13), that is attached to and covering an end portion of the laser rod (13), that has an opening defining portion (62) that forms an opening whose diameter is smaller than a diameter of an outer periphery of the end surface (13b), and that limits a laser light path region in the end surface (13b) of the laser rod (13) to a region inside of the outer periphery of the end surface(13b).

2. The solid-state laser device (1) according to claim 1, wherein a distance between the opening defining portion (62) of the end-surface protection member (60) and the end surface (13b) of the laser rod (13) is 0.5 mm or smaller.

3. The solid-state laser device (1) according to claim 1, wherein the opening defining portion (62) of the end-surface protection member (60) and the end surface (13b) of the laser rod (13) are in contact with each other.

4. The solid-state laser device (1) according to any one of claims 1 to 3, wherein the opening defining portion (62) of the end-surface protection member (60) comprises a tapered portion (62a) whose opening diameter decreases toward the laser rod (13).

5. The solid-state laser device (1) according to any one of claims 1 to 4, wherein the end-surface protection member (60) has a tubular portion that supports the opening defining portion (62), and the tubular portion (64,64A) is fitted onto and attached to the end portion of the laser rod (13) including the end surface (13b).

6. The solid-state laser device (1) according to claim 5, comprising:
a laser chamber (30) that contains at least a part of the laser rod (13) and that has a hole (34) having a columnar shape that is shorter than a longitudinal axial length of the laser rod (13),
wherein the laser rod (13) is inserted through the hole (34) of the laser chamber (30) and is supported by the laser chamber (30) in a state in which both end portions of the laser rod (13) are exposed from the hole (34), and
wherein the tubular portion (64A) of the end-surface protection member (60) has a shape that covers an entire region of a side surface of the end portion exposed from the hole (34).

7. The solid-state laser device (1) according to any one of claims 1 to 5, comprising:
a laser chamber that contains at least a part of the laser rod (13) and that has a hole (34) having a columnar shape that is shorter than a longitudinal axial length of the laser rod (13),
wherein the laser rod (13) is inserted through the hole (34) of the laser chamber (30) and is supported by the laser chamber (30) in a state in which both end portions of the laser rod (13) are exposed from the hole (34),
wherein an O-ring (36) is disposed at an exposed root of an end portion of the laser rod (13) including the end surface where the end-surface protection member (60) is disposed, the exposed root being exposed from the hole (34), and
wherein the solid-state laser device (1) comprises a cover member (38) that is disposed on a side surface of the laser rod (13) between the O-ring (36) and the end surface and that blocks incidence of stray light on the O-ring (36).

8. The solid-state laser device (1) according to any one of claims 1 to 7, wherein the end-surface protection member (60) is made of at least one of a ceramic, glass, or a fluororesin.

9. The solid-state laser device (1) according to any one of claims 1 to 8, wherein the laser rod (13) is made of an alexandrite crystal.

10. The solid-state laser device (1) according to any one of claims 1 to 9, wherein a rod diameter of the laser rod (13) is 3 mm or smaller.

## Patentansprüche

1. Festkörper-Laservorrichtung (1) umfassend:
einen aus einem Spiegelpaar (11, 12) aufgebauten Resonator;
einen Laserstab (13), der in dem Resonator angeordnet ist, wobei der Laserstab (13) einen Antireflexionsfilm (14) auf einer Endoberfläche (13b) desselben umfasst und einen abgeschrägten Abschnitt (13d) an einer periphären Kante der Endoberfläche (13b) aufweist; und
ein Endoberflächen-Schutzglied (60), das an einer der Endoberfläche (13b) des Laserstabs (13) gegenüberliegenden Position angeordnet ist, das an einen Endabschnitt des Laserstabs (13) angebracht ist und diese abdeckt, das einen Öffnungs-Definitionsabschnitt (62) aufweist, der eine Öffnung ausbildet, dessen Durchmesser kleiner als der Durchmesser einer äußeren Peripherie der Endoberfläche (13b) ist, und das eine Laserlichtpfadregion auf der Endoberfläche (13b) des Laserstabs (13) gegenüber einer Region im Innern der äußeren Peripherie der Endoberfläche (13b) abgrenzt.

2. Festkörper-Laservorrichtung (1) nach Anspruch 1, wobei ein Abstand zwischen dem Öffnungs-Definitionsabschnitt (62) des Endoberflächen-Schutzglieds (60) und der Endoberfläche (13b) des Laserstabs (13) 0,5 mm oder weniger beträgt.

3. Festkörper-Laservorrichtung (1) nach Anspruch 1, wobei der Öffnungs-Definitionsabschnitt (62) des Endoberflächen-Schutzglieds (60) und die Endoberfläche (13b) des Laserstabs (13) miteinander in Kontakt stehen.

4. Festkörper-Laservorrichtung (1) nach einem der Ansprüche 1 bis 3, wobei der Öffnungs-Definitionsabschnitt (62) des Endoberflächen-Schutzglieds (60) einen sich verjüngenden Abschnitt (62a) aufweist, dessen Öffnungsdurchmesser zum Laserstab (13) hin abnimmt.

5. Festkörper-Laservorrichtung (1) nach einem der Ansprüche 1 bis 4, wobei das Endoberflächen-Schutzglied (60) einen röhrenförmigen Abschnitt aufweist, der den Öffnungs-Definitionsabschnitt (62) stützt und der röhrenförmigen Abschnitt (64, 64A) auf den Endabschnitt des Laserstabs (13), umfassend die Endoberfläche (13b), angepasst und daran angebracht ist.

6. Festkörper-Laservorrichtung (1) nach Anspruch 5, umfassend:
eine Laserkammer (30), die zumindest einen Teil des Laserstabs (13) enthält und die ein Loch (34) mit einer spaltenartigen Form aufweist, die kürzer ist als eine Längsachsenlänge des Laserstabs (13),
wobei der Laserstab (13) durch das Loch (34) der Laserkammer (30) eingesetzt ist und von der Laserkammer (30) in einem Zustand gehalten wird, in welchem beide Endabschnitte des Laserstabs (13) gegenüber dem Loch (34) freiliegen,
wobei der röhrenförmige Abschnitt (64) des Endoberflächen-Schutzglieds (60) eine Form aufweist, die eine gesamte Region einer Seitenoberfläche des gegenüber dem Loch (34) freiliegenden Endabschnitts abdeckt.

7. Festkörper-Laservorrichtung (1) nach einem der Ansprüche 1 bis 5, umfassend:
eine Laserkammer, die zumindest einen Teil des Laserstabs (13) enthält und die ein Loch (34) mit einer spaltenartigen Form aufweist, die kürzer ist als eine Längsachsenlänge des Laserstabs (13),
wobei der Laserstab (13) durch das Loch (34) der Laserkammer (30) eingesetzt ist und von der Laserkammer (30) in einem Zustand gehalten wird, in welchem beide Endabschnitte des Laserstabs (13) gegenüber dem Loch (34) freiliegen,
wobei ein O-Ring (36) an einer freiliegenden Wurzel eines Endabschnitts des Laserstabs (13) angeordnet ist, umfassend die Endoberfläche, an der das Endoberflächen-Schutzglied (60) angeordnet ist, wobei die freiliegende Wurzel gegenüber dem Loch (34) freiliegt, und
wobei die Festkörper-Laservorrichtung (1) ein Abdeckglied (38) umfasst, das auf einer Seitenoberfläche des Laserstabs (13) zwischen dem O-Ring (36) und der Endoberfläche angeordnet ist, die ein Einfallen von Streulicht auf den O-Ring (36) blockiert.

8. Festkörper-Laservorrichtung (1) nach einem der Ansprüche 1 bis 7, wobei das Endoberflächen-Schutzglied (60) aus wenigstens einem von Keramik, Glas oder einem Fluorokunststoff gemacht ist.

9. Festkörper-Laservorrichtung (1) nach einem der Ansprüche 1 bis 8, wobei der Laserstab (13) aus einem Alexandrit-Kristall gemacht ist.

10. Festkörper-Laservorrichtung (1) nach einem der Ansprüche 1 bis 9, wobei ein Durchmesser des Laserstabs (13) 3 Millimeter oder weniger beträgt.

## Revendications

1. Dispositif laser à solide (1), comprenant :
un résonateur composé d'une paire de miroirs (11, 12) ;
un barreau laser (13) disposé dans le résonateur, et le barreau laser (13) comprenant un film antireflet (14) sur une surface d'extrémité (13b) et présentant une portion chanfreinée (13d) sur un bord périphérique de la surface d'extrémité (13b), et
un élément protecteur de surface d'extrémité (60), lequel est disposé sur une position faisant face à la surface d'extrémité (13b) du barreau laser (13), et lequel est attaché sur une portion d'extrémité du barreau laser (13), et recouvre celle-ci, lequel présente une portion définissant une ouverture (62) qui forme une ouverture dont le diamètre est plus petit qu'un diamètre d'une périphérie extérieure de la surface d'extrémité (13b), et lequel limite une région de trajet de lumière laser dans la surface d'extrémité (13b) du barreau laser (13) à une région à l'intérieur de la périphérie extérieure de la surface d'extrémité (13b).

2. Dispositif laser à solide (1) selon la revendication 1, dans lequel une distance entre la portion définissant une ouverture (62) de l'élément protecteur de surface d'extrémité (60) et la surface d'extrémité (13b) du barreau laser (13) est inférieure ou égale à 0,5 mm.

3. Dispositif laser à solide (1) selon la revendication 1, dans lequel la portion définissant une ouverture (62) de l'élément protecteur de surface d'extrémité (60) et la surface d'extrémité (13b) du barreau laser (13) sont en contact l'une avec l'autre.

4. Dispositif laser à solide (1) selon l'une quelconque des revendications 1 à 3, dans lequel la portion définissant une ouverture (62) de l'élément protecteur de surface d'extrémité (60) comprend une portion de diminution progressive (62a) dont le diamètre d'ouverture diminue vers le barreau laser (13).

5. Dispositif laser à solide (1) selon l'une quelconque des revendications 1 à 4, dans lequel l'élément protecteur de surface d'extrémité (60) présente une portion tubulaire, laquelle supporte la portion définissant une ouverture (62), et la portion tubulaire (64, 64A) est montée et fixée sur la surface d'extrémité du barreau laser (13) incluant la surface d'extrémité (13b).

6. Dispositif laser à solide (1) selon la revendication 5, comprenant :
une chambre laser (30), laquelle contient au moins une partie du barreau laser (13) et présente un trou (34) présentant une forme colonnaire plus courte qu'une longueur axiale longitudinale du barreau laser (13),
dans lequel le barreau laser (13) est introduit à travers le trou (34) de la chambre laser (30) et est supporté par la chambre laser (30) dans un état où les deux portions d'extrémité du barreau laser (13) sont exposées à partir du trou (34), et
dans lequel la portion tubulaire (64A) de l'élément protecteur de surface d'extrémité (60) présente une forme qui recouvre une région entière d'une surface latérale de la portion d'extrémité exposée à partir du trou (34).

7. Dispositif laser à solide (1) selon l'une quelconque des revendications 1 à 5, comprenant :
une chambre laser, laquelle contient au moins une partie du barreau laser (13) et présente un trou (34) présentant une forme colonnaire plus courte qu'une longueur axiale longitudinale du barreau laser (13),
dans lequel le barreau laser (13) est introduit à travers le trou (34) de la chambre laser (30) et est supporté par la chambre laser (30) dans un état où les deux portions d'extrémité du barreau laser (13) sont exposées à partir du trou (34) ;
dans lequel un joint torique (36) est disposé sur une racine exposée d'une portion d'extrémité du barreau laser (13) incluant la surface d'extrémité où l'élément protecteur de surface d'extrémité (60) est disposé, la racine exposée étant exposée à partir du trou (34), et
dans lequel le dispositif laser à solide (1) comprend un élément de couverture (38), lequel est disposé sur une surface latérale du barreau laser (13) entre le joint torique (36) et la surface d'extrémité, et bloque l'incidence de la lumière parasite sur le joint torique (36).

8. Dispositif laser à solide (1) selon l'une quelconque des revendications 1 à 7, dans lequel l'élément protecteur de surface d'extrémité (60) est fabriqué dans au moins un élément parmi une céramique, du verre, ou une résine fluorée.

9. Dispositif laser à solide (1) selon l'une quelconque des revendications 1 à 8, dans lequel le barreau laser (13) est fabriqué à partir d'un cristal d'alexandrite.

10. Dispositif laser à solide (1) selon l'une quelconque des revendications 1 à 9, dans lequel un diamètre du barreau laser (13) est inférieur ou égal à 3 mm.
